# EUROPÄISCHE PATENTANMELDUNG

(11) **EP 1 912 374 A1**
(43) Veröffentlichungstag der Anmeldung: **16.04.2008**
(21) Anmeldenummer: 06021247.9
(22) Anmeldetag: 10.10.2006
(51) Int. Cl.: H04L 5/02, H04L 27/00, H04L 1/00

(54) **Datenübertragung in einem Mehrnutzer-OFDM-System mit adaptiver Modulation**

(71) Anmelder: Nokia Siemens Networks GmbH & Co. KG, 81541 München (DE); Fraunhofer-Gesellschaft zur Förderung der angewandten Forschung e.V., 80686 München (DE)
(72) Erfinder: Gaebler, Holger, 14478 Postdam (DE); Haustein, Thomas, Dr., 81735 München (DE); Jungnickel, Volker Dr., 10318 Berlin (DE); Zirwas, Wolfgang, 82194 Gröbenzell (DE)

(57) **Zusammenfassung**

Die Erfindung betrifft ein Verfahren zur Bearbeitung von per Funk zu versendenden Informationen (DS), bei welchem erste Bits (DS1) als erste Anzahl von N-Tupeln und zweite Bits (DSN) als zweite Anzahl von N-Tupeln vorliegen. Die ersten Bits sind unter Verwendung einer ersten Gruppe von Subbändern eines Frequenzbandes (CHUNK 1) zu versenden, die zweiten Bits unter Verwendung einer zweiten Gruppe von Subbändern des Frequenzbandes (CHUNK N). Für die ersten Bits wird ein erstes Modulationsverfahren (MOD X) und für die zweiten Bits ein zweites Modulationsverfahren (MOD Y) eingesetzt. Die ersten Bits werden umgeordnet, wobei M-Tupel gebildet werden, und gemäß dem ersten Modulationsverfahren wird aus jeweils einem M-Tupel ein Symbol gebildet. Die zweiten Bits werden umgeordnet, wobei P-Tupel gebildet werden, und gemäß dem zweiten Modulationsverfahren wird aus jeweils einem P-Tupel ein Symbol gebildet, wobei M ≠ P. Weiterhin betrifft die Erfindung ein entsprechendes Verfahren zur Bearbeitung von per Funk empfangenen Informationen, sowie Basisstationen und Mobilfunkstationen zur Durchführung der Verfahren.

## Beschreibung

Die Erfindung betrifft Verfahren zur Bearbeitung von Informationen, wobei erste Informationen unter Verwendung einer ersten Gruppe von Subbändern eines Frequenzbandes und zweite Informationen unter Verwendung einer zweiten von der ersten Gruppe unterschiedlichen Gruppe von Subbändern des Frequenzbandes zu versenden sind oder empfangen wurden.

In Funkkommunikationssystemen werden Nachrichten, beispielsweise mit Sprachinformation, Bildinformation, Videoinformation, SMS (Short Message Service), MMS (Multimedia Messaging Service) oder anderen Daten, mit Hilfe von elektromagnetischen Wellen über eine Funkschnittstelle zwischen sendender und empfangender Station übertragen. Bei den Stationen kann es sich hierbei je nach konkreter Ausgestaltung des Funkkommunikationssystems um verschiedenartige Teilnehmerstationen oder netzseitige Funkstationen wie Repeater, Funkzugangspunkte oder Basisstationen handeln. In einem Mobilfunkkommunikationssystem handelt es sich bei zumindest einem Teil der Teilnehmerstationen um mobile Funkstationen. Das Abstrahlen der elektromagnetischen Wellen erfolgt mit Trägerfrequenzen, die in dem für das jeweilige System vorgesehenen Frequenzband liegen.

Derzeitige Mobilfunkkommunikationssysteme sind oftmals als zellulare Systeme z.B. nach dem Standard GSM (Global System for Mobile Communication) oder UMTS (Universal Mobile Telecommunications System) mit einer Netzinfrastruktur bestehend z.B. aus Basisstationen, Einrichtungen zur Kontrolle und Steuerung der Basisstationen und weiteren netzseitigen Einrichtungen ausgebildet. Ein weiteres Beispiel stellen Breitbandnetze mit drahtlosem Zugang beispielsweise gemäß IEEE 802.16 dar. Zukünftige Mobilfunkkommunikationssysteme können z.B. Weiterentwicklungen von UMTS, als LTE (Long Term Evolution) bezeichnet, oder Systeme der vierten Generation, sowie Ad-hoc-Netze sein. Außer weiträumig organisierten (supralokalen) zellularen, hierarchischen Funknetzen existieren drahtlose lokale Netze (WLANs, Wireless Local Area Networks) mit einem in der Regel räumlich deutlich stärker begrenzten Funkabdeckungsbereich. Beispiele verschiedener Standards für WLANs sind HiperLAN, DECT, IEEE 802.11, Bluetooth und WATM.

Der Zugriff von Teilnehmerstationen auf das gemeinsame Übertragungsmedium wird bei Funkkommunikationssystemen durch Vielfachzugriffsverfahren/Multiplexverfahren (Multiple Access, MA) geregelt. Bei diesen Vielfachzugriffen kann das Übertragungsmedium im Zeitbereich (Time Division Multiple Access, TDMA), im Frequenzbereich (Frequency Division Multiple Access, FDMA), im Codebereich (Code Division Multiple Access, CDMA) oder im Raumbereich (Space Division Multiple Access, SDMA) zwischen den Teilnehmerstationen aufgeteilt werden. Auch Kombinationen von Vielfachzugriffsverfahren sind möglich, wie z.B. die Kombination eines Frequenzbereichs-Vielfachzugriffsverfahrens mit einem Codebereichs-Vielfachzugriffsverfahren.

Um eine möglichst effiziente Übertragung von Daten zu erreichen, kann man das gesamte zur Verfügung stehende Frequenzband in mehrere Subbänder bzw. Frequenz-Unterträger zerlegen (Multicarrier- bzw. Mehrträgerverfahren). Die den Mehrträgersystemen zugrunde liegende Idee ist es, das Ausgangsproblem der Übertragung eines breitbandigen Signals in die Übertragung mehrerer schmalbandiger Signale zu überführen. Dies hat unter anderem den Vorteil, dass die am Empfänger erforderliche Komplexität reduziert werden kann. Ferner ermöglicht die Aufteilung der verfügbaren Bandbreite in mehrere schmalbandige Subbänder eine deutlich höhere Granularität der Datenübertragung hinsichtlich der Verteilung der zu übertragenden Daten auf die unterschiedlichen Subbänder, d.h. die Funkressourcen können mit einer großen Feinheit auf die zu übertragenden Daten bzw. auf die Teilnehmerstationen verteilt werden. Insbesondere bei Übertragungen mit variabler Datenrate oder bei burstartigem Datenverkehr kann die verfügbare Bandbreite durch die Zuweisung einer Anzahl von Subbändern an unterschiedliche Teilnehmerstationen effizient ausgenutzt werden. Ein Beispiel für ein Mehrträgerübertragungsverfahren ist OFDM (Orthogonal Frequency Division Multiplexing), bei welchem für die Subbänder zeitlich annähernd rechteckige Pulsformen verwendet werden. Der Frequenzabstand der Subbänder wird derart gewählt, dass im Frequenzraum bei derjenigen Frequenz, bei welcher das Signal eines Subbands ausgewertet wird, die Signale der anderen Subbänder einen Nulldurchgang aufweisen. Somit sind die Subbänder orthogonal zueinander.

Der Erfindung liegt die Aufgabe zugrunde, Verfahren zur Bearbeitung von per Funk zu versendenden und per Funk empfangenen Informationen vorzustellen, wobei zur Funkkommunikation ein in eine Mehrzahl von Subbändern aufgeteiltes Frequenzband eingesetzt wird.

Diese Aufgabe wird durch ein Verfahren mit den Merkmalen des Anspruchs 1, sowie durch ein Verfahren und durch Vorrichtungen mit Merkmalen von nebengeordneten Ansprüchen gelöst. Vorteilhafte Ausgestaltungen und Weiterbildungen sind Gegenstand von Unteransprüchen.

Bei dem erfindungsgemäßen Verfahren zur Bearbeitung von per Funk zu versendenden Informationen liegen erste Bits als erste Anzahl von N-Tupeln vor, und zweite Bits als von der ersten Anzahl unterschiedliche zweite Anzahl von N-Tupeln. Die ersten Bits sind unter Verwendung einer ersten Gruppe von Subbändern eines Frequenzbandes und die zweiten Bits unter Verwendung einer zweiten von der ersten Gruppe unterschiedlichen Gruppe von Subbändern des Frequenzbandes zu versenden. Für die ersten Bits wird ein erstes Modulationsverfahren und für die zweiten Bits ein zweites von dem ersten Modulationsverfahren unterschiedliches Modulationsverfahren eingesetzt.

Die ersten Bits werden umgeordnet, wobei M-Tupel gebildet werden, und gemäß dem ersten Modulationsverfahren wird aus jeweils einem M-Tupel ein Symbol gebildet. Die zweiten Bits werden umgeordnet, wobei P-Tupel gebildet werden, und gemäß dem ersten Modulationsverfahren wird aus jeweils einem P-Tupel ein Symbol gebildet. Hierbei ist M ungleich P.

Senderseitig liegen zu versendende Bits vor, wobei die ersten Bits auf der ersten Gruppe von Subbändern zu versenden sind und die zweiten Bits auf der zweiten Gruppe von Subbändern. Dementsprechend wurde eine Entscheidung hinsichtlich der für die ersten und die zweiten Bits zu verwendenden Funkressourcen bereits getroffen. Diese Entscheidung wird nach Abschluss der Bearbeitung der Bits durch Versendung auf der entsprechenden Gruppe von Subbändern umgesetzt. Die Bearbeitung der Bits vor der Versendung kann neben den erwähnten Schritten weitere Schritte umfassen, insbesondere eine Umwandlung von digitalen Informationen in analoge für die Funkversendung geeignete Signale.

Es wird für die ersten und die zweiten Bits jeweils eine Gruppe von Subbändern für die Versendung eingesetzt. Eine Gruppe besteht hierbei aus zwei oder mehr Subbändern, vorzugsweise entspricht jede Gruppe einem Block aus im Frequenzbereich benachbarten Subbändern. Die erste und die zweite Gruppe unterscheiden sich voneinander. Dies bedeutet, dass zumindest ein Subband Bestandteil der ersten Gruppe und nicht der zweiten Gruppe ist oder dass zumindest ein Subband Bestandteil der zweiten Gruppe und nicht der ersten Gruppe ist. Vorzugsweise weisen die beiden Gruppen keine Überschneidung auf, d.h. es existiert kein Subband, welches sowohl Bestandteil der zweiten als auch der ersten Gruppe ist. Im letztgenannten Fall stehen Subbänder, welche für die erste Gruppe verwendet werden, nicht für die zweite Gruppe zur Verfügung.

Das für die ersten Bits verwendete Modulationsverfahren unterscheidet sich von demjenigen, welches für die zweiten Bits verwendet wird. Die Modulationsverfahren entsprechen hierbei der Art der Zusammenfassung von Bits zu Symbolen. Bei dem ersten Modulationsverfahren werden jeweils M Bits zu einem Symbol zusammengefasst, während bei dem zweiten Modulationsverfahren jeweils P Bits zu einem Symbol zusammengefasst werden. Bevor diese Modulation erfolgen kann, werden aus den anfänglich vorliegenden N-Tupeln der ersten und zweiten Bits M-Tupel von ersten Bits und P-Tupel von zweiten Bits gebildet. M, N und P sind jeweils ganze Zahlen. Während M und P sich unterscheiden, entsprechend der unterschiedlichen Modulationsverfahren, ist es möglich, dass M oder P gleich N ist. Vorzugsweise jedoch gilt *M≠N* und *P≠N ;* in diesem Fall müssen sowohl die ersten als auch die zweiten Bits vor der Modulation neu gruppiert werden.

Bei der Bildung von M-Tupeln und P-Tupeln aus den jeweiligen N-Tupeln kann die Reihenfolge der Bits geändert werden. So kann ein Bit, welches anfänglich innerhalb eines N-Tupels vor einem anderen Bit steht, nach der Bildung von M-Tupeln bzw. P-Tupeln in einem M-Tupel bzw. P-Tupel stehen, welches nach dem M-Tupel bzw. P-Tupel des anderen Bits steht.

Die erläuterte Bearbeitung der ersten Bits erfolgt vorzugsweise nicht gleichzeitig, sondern vor oder nach derjenigen der zweiten Bits. In diesem Fall findet eine serielle Bearbeitung der auf verschiedenen Gruppen von Subbändern zu versendenden Bits statt.

In Weiterbildung der Erfindung ist die Anzahl der M-Tupel gleich der Anzahl der P-Tupel. In diesem Fall liegen anfänglich unterschiedlich viele N-Tupel von ersten und zweiten Bits vor, während nach der Neugruppierung und vor der Modulation eine gleiche Anzahl von Tupeln von ersten und zweiten Bits vorhanden sind. Hierbei unterscheiden sich jedoch die Größen dieser Tupel. Durch die Neugruppierung wird die Anzahl der ersten Bits und die Anzahl der zweiten Bits nicht geändert.

Besonders vorteilhaft ist es, wenn die Bildung von M-Tupeln folgt, indem M N-Tupel der ersten Bits in parallele Schieberegister eingegeben werden. Dies bedeutet, dass parallel M Schieberegister betätigt werden, wobei gleichzeitig jedes der M Schieberegister ein N-Tupel der ersten Bits aufnimmt. Die parallele Ausgabe der M Schieberegister wird als M-Tupel zusammengefasst. Entsprechendes ist auch für die Bildung der P-Tupel der zweiten Bits vorteilhaft. Es können die gleichen P parallelen Schieberegister zur Bildung der P-Tupel und zur Bildung der M-Tupel verwendet werden. Dies eignet sich für die serielle Bearbeitung der ersten und der zweiten Bits und ermöglicht einen sparsamen Aufbau der Verarbeitungseinrichtung.

In Ausgestaltung der Erfindung beinhaltet ein M-Tupel jeweils Bits von M verschiedenen N-Tupeln der ersten Bits und/oder beinhaltet ein P-Tupel jeweils Bits von P verschiedenen N-Tupeln der zweiten Bits. Dies gilt vorzugsweise für alle gebildeten M-Tupel bzw. P-Tupel. Hierdurch wird ein Interleaving der Bits realisiert.

Einer Weiterbildung der Erfindung gemäß erfolgt die Versendung der ersten Bits bzw. der den ersten Bits entsprechenden Information gleichzeitig zur Versendung der zweiten Bits bzw. der den zweiten Bits entsprechenden Information. Die Versendung erfolgt hierbei wie bereits erwähnt nicht in Form von Bits, sondern nach erfolgter Modulation und gegebenenfalls weiterer die Versendung vorbereitender Schritte.

Einer bevorzugten Weiterbildung der Erfindung gemäß erfolgt die Versendung der ersten Bits bzw. der den ersten Bits entsprechenden Information unter Verwendung einer ersten Funkressourceneinheit und die Versendung der zweiten Bits bzw. der den zweiten Bits entsprechenden Information unter Verwendung einer zweiten Funkressourceneinheit, wobei die Funkressourceneinheiten jeweils ein Rechteck in einer Subband-Zeit-Ebene darstellen und die erste und die zweite Funkressourceneinheit gleich groß sind. In der Subband-Zeit-Ebene sind die zur Verfügung stehenden Funkressourcen in einer Dimension in Form von Subbändern und in der anderen Dimension in Form von Zeiteinheiten aufgetragen. Ein Rechteck in der Subband-Zeit-Ebene besteht somit aus einem oder mehreren benachbarten Subbändern und einem oder mehreren benachbarten Zeiteinheiten. Rechtecke gleicher Größe bestehen dementsprechend aus der gleichen Anzahl von Subbändern und Zeiteinheiten. Vorzugsweise sind die Rechtecke der ersten und der zweiten Bits so gegeneinander verschoben, dass sie keine Überlappung aufweisen. Werden die ersten und die zweiten Bits gleichzeitig versendet, ist diese Verschiebung lediglich in der Richtung der Subbänder vorhanden.

In Ausgestaltung der Erfindung werden nach der Bildung der Symbole Informationen über die I-Q-Ebene-Positionen der Symbole gespeichert, wobei für jede Zeiteinheit der Rechtecke ein eigener Speicher verwendet wird. Diese Art der Speicherung ermöglicht den Übergang von einer rechtecks-weisen zu einer zeiteinheits-weisen Betrachtung.

Vorteilhaft ist es, wenn die ersten Bits von einer netzseitigen Funkstation an eine erste Teilnehmerstation und die zweiten Bits von der netzseitigen Funkstation an eine zweite Teilnehmerstation versendet werden. Dies entspricht der Anwendung des Verfahrens auf die Abwärtsrichtung. Zusätzlich oder alternativ ist es auch möglich, die Erfindung auf die Aufwärtsrichtung anzuwenden.

In Ausgestaltung der Erfindung werden die Anzahl der ersten Bits und die Anzahl der zweiten Bits ermittelt unter Verwendung der Größe der jeweils zur Versendung zu verwendenden Funkressourceneinheiten und des jeweils einzusetzenden Modulationsverfahrens. Dies trägt der Tatsache Rechnung, dass durch ein höherwertiges Modulationsverfahren und durch einen größeren Umfang an Funkressourcen mehr Bits übertragen werden können. Die ersten Bits können nach Ermittlung ihrer Anzahl aus einem ersten einem ersten Empfänger zugeordneten Speicher ausgelesen werden, die zweiten Bits können nach Ermittlung ihrer Anzahl aus einem zweiten einem zweiten Empfänger zugeordneten Speicher ausgelesen werden. In den beiden Speichern befinden sich vorzugsweise ausschließlich für den jeweiligen Empfänger bestimmte Bits.

Bei dem erfindungsgemäßen Verfahren zur Bearbeitung von per Funk empfangenen Informationen liegen erste unter Verwendung einer ersten Gruppe von Subbändern eines Frequenzbandes empfangene Symbole und zweite unter Verwendung einer zweiten von der ersten Gruppe unterschiedlichen Gruppe von Subbändern des Frequenzbandes empfangene Symbole vor. Für die ersten Symbole wird eine erstes Demodulationsverfahren und für die zweiten Symbole ein zweites von dem ersten Demodulationsverfahren unterschiedliches Demodulationsverfahren eingesetzt. Nach der Demodulation liegen gemäß dem ersten Demodulationsverfahren ausgehend von den ersten Symbolen erste Bits als M-Tupel und gemäß dem zweiten Demodulationsverfahren ausgehend von den zweiten Symbolen zweite Bits als P-Tupel vor, wobei M ungleich P ist. Die ersten Bits werden umgeordnet, wobei N-Tupel gebildet werden. Auch die zweiten Bits werden umgeordnet, wobei N-Tupel gebildet werden.

Die obigen Ausführungen bezüglich des senderseitigen Verfahrens gelten entsprechend auch für das empfängerseitige Verfahren. Dies gilt auch für die Ausgestaltungen und Weiterbildungen. Die empfängerseitige Verarbeitung kann weitere Schritte umfassen, so z.B. Schritte der Gewinnung der Symbole aus einem empfangenen analogen Signal.

Der erfindungsgemäßen Funkstation zur Bearbeitung von per Funk zu versendenden Informationen liegen erste Bits als erste Anzahl von N-Tupeln vor, und zweite Bits als von der ersten Anzahl unterschiedliche zweite Anzahl von N-Tupeln. Die Funkstation umfasst Mittel zum Versenden der ersten Bits unter Verwendung einer ersten Gruppe von Subbändern eines Frequenzbandes und der zweiten Bits unter Verwendung einer zweiten von der ersten Gruppe unterschiedlichen Gruppe von Subbändern des Frequenzbandes, sowie Mittel zum Verwenden für die ersten Bits eines ersten Modulationsverfahrens und für die zweiten Bits eines zweiten von dem ersten Modulationsverfahren unterschiedlichen Modulationsverfahrens. Weiterhin sind vorhanden: Mittel zum Umordnen der ersten Bits, wobei M-Tupel gebildet werden, und Mittel zum Bilden von Symbolen gemäß dem ersten Modulationsverfahren aus jeweils einem M-Tupel, sowie Mittel zum Umordnen der zweiten Bits, wobei P-Tupel gebildet werden, und Mittel zum Bilden von Symbolen gemäß dem zweiten Modulationsverfahren aus jeweils einem P-Tupel. Hierbei ist M ungleich P.

Der erfindungsgemäßen Funkstation zur Bearbeitung von per Funk empfangenen Informationen liegen erste unter Verwendung einer ersten Gruppe von Subbändern eines Frequenzbandes empfangene Symbole und zweite unter Verwendung einer zweiten von der ersten Gruppe unterschiedlichen Gruppe von Subbändern des Frequenzbandes empfangene Symbole vor. Die Funkstation weist Mittel auf zum Verwenden eines ersten Demodulationsverfahrens für die ersten Symbole und eines zweiten von dem ersten Demodulationsverfahren unterschiedlichen Demodulationsverfahrens für die zweiten Symbole. Hierbei liegen nach der Demodulation gemäß dem ersten Demodulationsverfahren ausgehend von den ersten Symbolen erste Bits als M-Tupel und gemäß dem zweiten Demodulationsverfahren ausgehend von den zweiten Symbolen zweite Bits als P-Tupel vor, wobei P ungleich M ist. Ferner umfasst die Funkstation Mittel zum Umordnen der ersten Bits, wobei N-Tupel gebildet werden, und auch zum Umordnen der zweiten Bits, wobei N-Tupel gebildet werden.

Die erfindungsgemäßen Funkstationen eignen sich insbesondere zur Durchführung der erfindungsgemäßen Verfahren, wobei dies auch auf die Ausgestaltungen und Weiterbildungen zutreffen kann. Hierzu können sie weitere geeignete Mittel umfassen.

Im folgenden wird die Erfindung anhand eines Ausführungsbeispiels näher erläutert. Dabei zeigen:
- Figur 1:: einen Ausschnitt aus einem Mobilfunkkommunikationssystem,
- Figur 2:: Teile einer netzseitigen Funkstation,
- Figur 3:: einzelne Bestandteile der Figur 2.

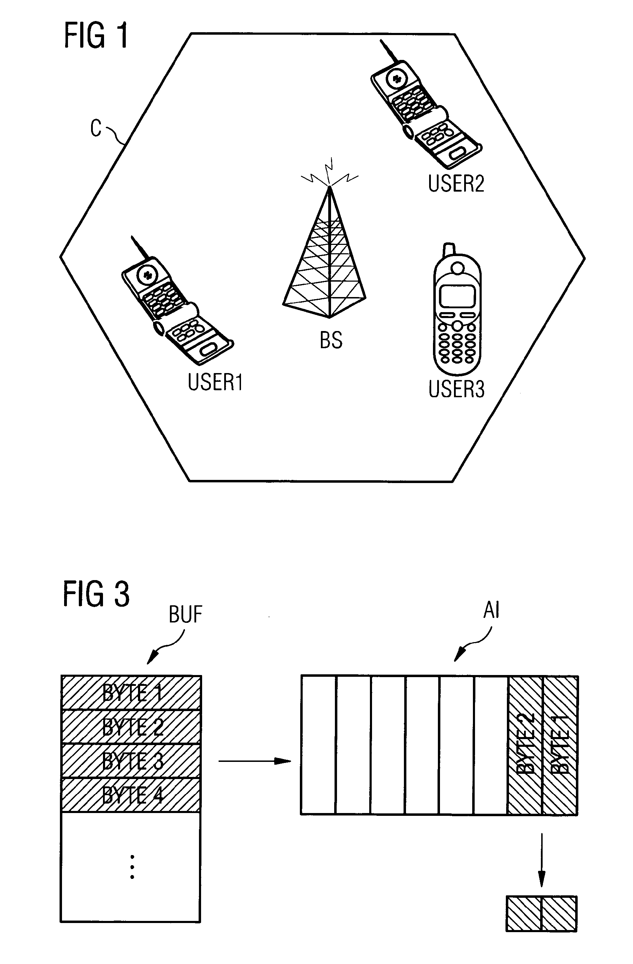

Der in Figur 1 dargestellte Ausschnitt aus einem Mobilfunkkommunikationssystem zeigt die Funkzelle C der netzseitigen Funkstation BS. In der Funkzelle C befinden sich die Teilnehmerstationen USER1, USER2 und USER3, welche mit der netzseitigen Funkstation BS über Funk kommunizieren. Zur Kommunikation zwischen der netzseitigen Funkstation BS und den Teilnehmerstationen USER1, USER2 und USER3 wird das Übertragungsverfahren OFDM eingesetzt. Dementsprechend wird ein Frequenzband genutzt, welches in eine Vielzahl von Subbändern aufgeteilt ist. Im folgenden wird die Versendung von Signalen in Abwärtsrichtung, d.h. von der netzseitigen Funkstation BS zu den Teilnehmerstationen USER1, USER2 und USER3 betrachtet.

Den Teilnehmerstationen USER1, USER2 und USER3 werden für die Abwärtskommunikation Funkressourcen in Form von Chunks zugewiesen. Unter einem Chunk wird hier die kleinste einer Teilnehmerstation zuweisbare Funkressourceneinheit verstanden, welche sich aus einer bestimmten Anzahl von im Frequenzraum benachbarten Subbändern und einer bestimmten Anzahl von aneinandergrenzenden Zeitschlitzen, d.h. OFDM Symbolen, zusammensetzt. Die zeitliche Ausdehnung eines Chunks bildet ein TTI (Transmission Time Interval). Beispielsweise kann ein Chunk eine Größe von 25 Subbändern innerhalb von 7 OFDM Symbolen aufweisen; ein TTI hat in diesem Fall eine Länge von 7 OFDM Symbolen. Teile eines Chunks können für die Versendung von Signalisierungsinformationen eingesetzt werden, wie z.B. für Pilotsignale zur teilnehmerseitigen Kanalschätzung. In diesem Fall stehen die Funkressourcen eines Chunks nicht vollständig für Nutzinformationen zur Verfügung.

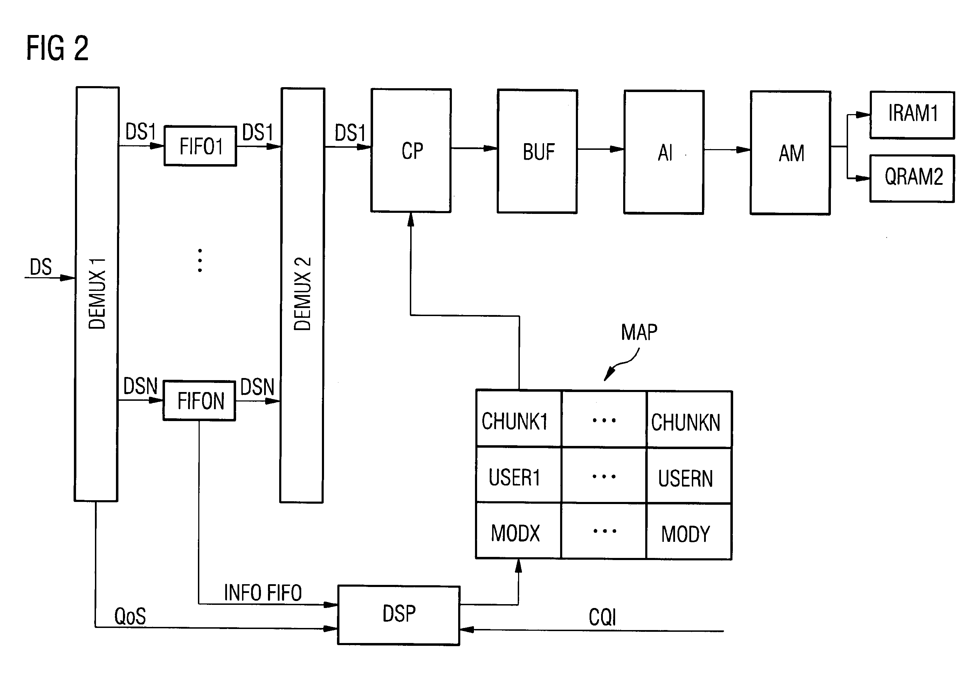

Figur 2 zeigt ausschnittsweise die netzseitige Funkstation BS. Der netzseitigen Funkstation BS liegt ein serieller Datenstrom DS vor, welcher Daten verschiedener Teilnehmerstationen enthält. Der Datenstrom DS wird der netzseitigen Funkstation BS über eine Standard-Verbindung, üblicherweise über eine Ethernet-Verbindung, übermittelt. Die Daten des Datenstroms DS können bereits bestimmte Bearbeitungsschritte, so z.B. das Hinzufügen von FEC Bits (FEC: Forward Error Correction), durchlaufen haben.

Die Daten des Datenstrom DS werden durch einen Demultiplexer DEMUX 1 auf eine Mehrzahl von FIFO-Speichern (FIFO: First In First Out) FIFO 1 bis FIFO N verteilt, wobei für jede Teilnehmerstation, an welche Daten in Abwärtsrichtung zu versenden sind, ein eigener FIFO-Speicher verwendet wird. In den FIFO-Speicher FIFO 1 der Teilnehmerstation USER1 werden dementsprechend die Daten DS1, welche für die Teilnehmerstation USER1 bestimmt sind, eingelesen, usw., und in den Speicher FIFO N der Teilnehmerstation USERN werden dementsprechend die Daten DSN, welche für die Teilnehmerstation USERN bestimmt sind, eingelesen. Die FIFO-Speicher FIFO 1 bis FIFO N enthalten daher die Daten, welche in den nächsten TTIs von der netzseitigen Funkstation BS an Teilnehmerstationen zu versenden sind.

In dem Bestandteil DSP (DSP: Digital Signal Processor) wird über die Zuweisung von Funkressourcen zu Teilnehmerstationen entschieden, d.h. von dem Bestandteil DSP wird das so genannte scheduling durchgeführt. Somit dient der Bestandteil DSP der Realisierung der so genannten "control plane" Funktionalität. Der Bestandteil DSP ist vorzugsweise Teil der netzseitigen Funkstation BS, es ist jedoch auch möglich, dass er Teil einer anderen netzseitigen Einrichtung ist und die für die netzseitige Funkstation BS relevanten von dem Bestandteil DSP ermittelten Informationen an die netzseitige Funkstation BS weitergegeben werden.

Durch den Bestandteil DSP wird für jedes zukünftige TTI eine Zuordnungstabelle MAP erstellt, welcher für jeden von der netzseitigen Funkstation BS verwendeten Chunk CHUNK 1 bis CHUNK N entnehmbar ist, welcher Teilnehmerstation der jeweilige Chunk für das jeweilige TTI zugewiesen ist. Weiterhin gibt die Zuordnungstabelle MAP an, welches Modulationsverfahren für den jeweiligen Chunk anzuwenden ist. Beispielhaft zeigt die in Figur 2 dargestellte Tabelle MAP für das nächste TTI an, dass der Chunk CHUNK 1 der Teilnehmerstation USER1 zugewiesen ist, wobei das Modulationsverfahren MOD X zu verwenden ist, und dass der Chunk CHUNK N der Teilnehmerstation USERN zugewiesen ist, wobei das Modulationsverfahren MOD Y zu verwenden ist.

Bei der Kommunikation in Abwärtsrichtung wird eine adaptive Modulation eingesetzt, d.h. das für eine Teilnehmerstation angewendete Modulationsverfahren kann den aktuellen Funkkanalbedingungen angepasst werden. So eignet sich die Verwendung eines hochwertigen Modulationsverfahrens, d.h. eines Modulationsverfahrens, bei welchem viele Bits zu einem Symbol zusammengefasst werden, für gute Kanalbedingungen. Bei schlechten Funkkanalbedingungen hingegen ist die Verwendung eines niedrigerwertigen Modulationsverfahrens, d.h. eines Modulationsverfahrens, bei welchem weniger Bits zu einem Symbol zusammengefasst werden, von Vorteil. Denn das niedrigerwertigere Modulationsverfahren ermöglicht bei der Detektion durch den Empfänger in Bezug auf ein empfangenes Symbol leichter die Entscheidung, welches Symbol senderseitig vorlag. Bei den Modulationsverfahren kann es sich z.B. um QPSK handeln, bei welchem jeweils 2 Bits zu einem Symbol zusammengefasst werden, oder 16-QAM, bei welchem jeweils 4 Bits zu einem Symbol zusammengefasst werden, oder 64-QAM, bei welchem jeweils 6 Bits zu einem Symbol zusammengefasst werden, oder 256-QAM, bei welchem jeweils 8 Bits zu einem Symbol zusammengefasst werden.

Bei der Entscheidung über das zu verwendende Modulationsverfahren berücksichtigt daher der Bestandteil DSP Informationen CQI, welche von dem Empfänger, d.h. von der jeweiligen Teilnehmerstation, zur Verfügung gestellt werden. Hierbei kann es sich um an sich bekannte Größen handeln, welche einen Rückschluss über die aktuellen Funkausbreitungsbedingungen zwischen der netzseitigen Funkstation BS und der jeweiligen Teilnehmerstation ermöglichen, wie z.B. um die aus UTMS bekannte Größe Channel Quality Indicator.

Beim scheduling berücksichtigt der Bestandteil DSP weiterhin, in welchem Umfang Daten zur Versendung an die jeweilige Teilnehmerstation vorliegen. Hierzu werden Informationen INFO FIFO betreffend die Füllstände der FIFO-Speicher FIFO 1 bis FIFO N zur Verfügung gestellt und ausgewertet. Ferner werden bei der Zuordnung von Funkressourcen zu Teilnehmerstationen Informationen QoS von höheren Schichten berücksichtigt, welche Anforderungen der jeweiligen Teilnehmerstation wiedergeben. Diese Anforderungen können z.B. die Priorisierung der jeweiligen Teilnehmerstation, die Datenrate und mögliche Verzögerungen betreffen. Der Algorithmus des scheduling ist für das Verständnis der Erfindung nicht relevant. Es wird davon ausgegangen, dass der netzseitigen Funkstation BS Informationen entsprechend der beschriebenen Tabelle MAP vorliegen.

Im folgenden wird das weitere Vorgehen in Bezug auf den ersten Chunk CHUNK 1 erläutert. Der Bestandteil CP erkennt anhand der Tabelle MAP, dass im folgenden TTI dieser Chunk CHUNK 1 zur Versendung von Daten DS1 der Teilnehmerstation USER1 verwendet werden soll. Weiterhin entnimmt der Bestandteil CP der Tabelle MAP, dass für den Chunk CHUNK 1 das Modulationsverfahren MOD X anzuwenden ist.

Bei verschiedenen Modulationsverfahren werden verschiedene Anzahlen von Bits zu einem Symbol zusammengefasst. Dementsprechend kann abhängig von dem verwendeten Modulationsverfahren pro Chunk eine unterschiedliche Anzahl von Nutzbits, d.h. von Bits des Speichers FIFO 1, übertragen werden. Unter Verwendung des durch die Tabelle MAP vorgegebenen Modulationsverfahrens MOD X berechnet der Bestandteil CP die Anzahl der durch den Chunk CHUNK 1 übertragbaren Bits des Speichers FIFO 1 und fordert diese Anzahl von dem FIFO-Speicher FIFO1 an. Die Daten werden von den FIFO-Speichern FIFO 1 bis FIFO N byteweise, d.h. in Tupeln von jeweils 8 Bits, ausgegeben. Es ist möglich, dass die FIFO-Speicher Tupel von anderer Größe als 8 Bits ausgeben, so z.B. 16er-Tupel; im folgenden wird jedoch beispielhaft davon ausgegangen, dass die FIFO-Speicher FIFO 1 bis FIFO N Bytes ausgeben. Über den Demultiplexer DEMUX 2 wird die durch den Bestandteil CP berechnete Anzahl von Bytes ausgegeben und in dem Speicher BUF abgelegt.

Der Buffer BUF, in Figur 3 detaillierter dargestellt, weist die Dimension M×8 auf, eignet sich somit maximal zur Aufnahme von *M*·8 Bits bzw. M Bytes. Hierbei entspricht die Zahl M der maximalen Anzahl von Bytes der Daten DS1 pro Chunk, d.h. der Anzahl von Bytes pro Chunk bei Verwendung des höchstwertigen Modulationsverfahrens. Es ist möglich, dass ein Chunk durch die M Bytes nicht vollständig gefüllt ist, sondern dass den M Bytes zu einem späteren Zeitpunkt bestimmte Signalisierungsinformationen hinzugefügt werden. In diesem Fall handelt es sich bei den M Bytes um die maximale Anzahl von Nutzbytes pro Chunk.

Abhängig von dem für den Chunk CHUNK 1 verwendeten Modulationsverfahren enthält der Speicher BUF eine bestimmte Anzahl von Bytes, in Figur 3 sind aus Gründen der Übersichtlichkeit lediglich die vier Bytes BYTE 1, BYTE 2, BYTE 3 und BYTE 4 dargestellt. Die zu versenden Bits liegen somit in dem Buffer BUF als ganzzahlige Anzahl von 8er-Tupeln vor.

Von dem Speicher BUF werden die Bytes in den darauf folgenden Bestandteil AI gegeben. Für die durch den Modulator AM durchzuführende Modulation, d.h. für die Umwandlung der Bits in Symbole, müssen die Bits in Tupeln vorliegen, wobei die Größe dieser Tupel durch das jeweilige Modulationsverfahren vorgegeben ist. Für QPSK müssen dementsprechend 2er-Tupel vorliegen, für 16-QAM 4er-Tupel, für 64-QAM 6er-Tupel, und für 256-QAM 8er-Tupel. Aufgabe des Bestandteils AI ist die Umwandlung der 8er-Tupel des Speichers BUF in die für die Modulation benötigten Tupel. In Figur 3 ist der Fall dargestellt, dass als Modulationsverfahren QPSK angewendet wird, so dass 2er-Tupel benötigt werden. Der Bestandteils AI muss in diesem Fall eine Umwandlung von 8er-Tupeln in 2er-Tupel durchführen.

Der Bestandteils AI umfasst 8 parallele Schieberegister, in Figur 3 durch 8 Spalten symbolisiert. Jedes Schieberegister weist hierbei Speicherplätze für genau ein Byte auf, so dass sich in dem Bestandteil AI gleichzeitig maximal 8·8=64 Bits befinden können. Da im betrachteten Beispiel 2er-Tupel für die Modulation benötigt werden, werden gleichzeitig jeweils 2 Schieberegister mit Bits des Buffers BUF gefüllt. Zu Beginn wird in ein erstes Schieberegister das erste Byte BYTE 1, in ein zweites der 8 Schieberegister das zweite Byte BYTE 2 eingegeben. Bei jeder Taktung der beiden Schieberegister wird ein 2er-Tupel von Bits ausgegeben. Das erste 2er-Tupel besteht somit aus dem ersten Bit des ersten Bytes BYTE 1 und dem ersten Bit des zweiten Bytes BYTE 2, das zweite 2er-Tupel besteht aus dem zweiten Bit des ersten Bytes BYTE 1 und dem zweiten Bit des zweiten Bytes BYTE 2, usw. Nach Ausgabe von 8 2er-Tupeln werden - in Figur 3 nicht dargestellt - die nächsten Bytes BYTE 3 und BYTE 4 in die gleichen beiden Schieberegister eingegeben. Für das Modulationsverfahren QPSK werden lediglich zwei der 8 parallelen Schieberegister des Bestandteils AI benötigt, für 16-QAM hingegen 4 Schieberegister, für 64-QAM 6 Schieberegister, und für 256-QAM jedes der 8 Schieberegister.

Der Bestandteil AI führt eine Umgruppierung der zu versendenden Bits aus, wobei die von dem Bestandteil AI ausgegebenen Tupel dem zu verwendenden Modulationsverfahren angepasst sind. Aufgrund der Realisierung der Umgruppierung durch parallele Schieberegister findet ein Interleaving der Bits statt, d.h. die Reihenfolge der Bits wird geändert.

Die Anzahl der Tupel, welche von dem Bestandteil AI ausgegeben wird, ist für jedes Modulationsverfahren gleich, lediglich die Größe der ausgegebenen Tupel hängt vom verwendeten Modulationsverfahren ab. Die Tatsache, dass unabhängig vom Modulationsverfahren jeweils gleich viele Tupel von Bits vorliegen, liegt darin begründet, dass pro chunk lediglich diese Höchstanzahl von Symbolen versendet werden kann.

Eine Alternative zur Verwendung der Mehrzahl paralleler Schieberegister ist die Verwendung eines einzelnen Schieberegisters, welches Tupel von Bits entsprechend dem jeweiligen Modulationsverfahren ausgibt. Dies erweist sich jedoch als äußerst aufwendig in der Realisierung. Denn die Geschwindigkeit, mit welcher das Schieberegister die Bits ausgeben muss, wächst linear mit der versendeten Datenrate, so dass bei Datenraten von GBit/s ein extrem schnelles Schieberegister benötigt würde. Bei Verwendung mehrerer paralleler Schieberegister hingegen ist die erforderliche Geschwindigkeit jedes einzelnen Schieberegisters geringer. Weiterhin müsste bei Verwendung eines einzigen Schieberegisters ein Wechsel der Taktung des Schieberegisters von Chunk zu Chunk erfolgen, da für verschiedene Chunks verschiedene Modulationsverfahren verwendet werden können.

Die von dem Bestandteil AI ausgegebenen Tupel von Bits werden in dem Modulator AM in Symbole umgewandelt. Jedes Symbol entspricht einem Punkt in der I-Q-Ebene. Die I-Werte werden in einem RAM-Speicher IRAM1 und die Q-Werte in einem RAM-Speicher QRAM2 abgelegt. Es existieren hierbei mehrere RAM-Speicher IRAM1 und QRAM2, wobei die Anzahl der RAM-Speicher IRAM1 und der RAM-Speicher QRAM2 jeweils der Anzahl von OFDM-Symbolen pro Chunk entspricht. Dies ermöglicht den Übergang von einer chunkweisen zu einer symbolweisen Verarbeitung. Denn während die Bestandteile CP, BUF, AI und AM jeweils die Bits des gesamten Chunks verarbeiten, wird durch die anschließende Inverse Fourier-Transformation, welche im Rahmen der OFDM-Verarbeitung von zu versendenden Daten erfolgt, jeweils auf Daten eines einzelnen OFDM-Symbols zugegriffen. Die RAM-Speicher IRAM1 und QRAM2 ermöglichen somit eine symbolweise Ausgabe der I- und Q-Daten für die Inverse Fourier-Transformation.

Die Speicherung der I- und Q-Werte in den RAM-Speicher IRAM1 und QRAM2 erfolgt vorzugsweise derart, dass die RAM-Speicher IRAM1 und QRAM2 jeweils über eine Anzahl von Zeilen verfügen, welche der Anzahl von Subbändern entspricht. In jede Zeile wird dann der I- bzw. Q-Wert des jeweiligen Subbandes eingetragen. Zusätzlich zur Befüllung der RAM-Speicher IRAM1 und QRAM2 mit den I- und Q-Werten der Daten DS1 können Signalisierungsinformationen eingetragen werden, so kann z.B. jede vierte Zeile -entsprechend jedem vierten Subband - für ein Pilotsignal genutzt werden.

Im folgenden wird ein konkretes Zahlenbeispiel betrachtet. Ein Chunk sei ein Rechteck mit den folgenden Maßen: 25 Subbänder und 7 OFDM Symbole; das Frequenzband bestehe aus 1200 Subbändern, d.h. es existieren pro TTI 48 Chunks. Somit können pro Chunk 25·7=175 Symbole übertragen werden. Hiervon werden 31 Symbole für Signalisierungsinformationen genutzt. Hinsichtlich der Nutzdaten gilt dann: bei dem Modulationsverfahren 256-QAM enthält ein Chunk 144 Bytes, bei dem Modulationsverfahren 64-QAM 108 Bytes, und bei dem Modulationsverfahren QPSK 36 Bytes. Für die Größe des Speichers BUF gilt daher M=144. Der Bestandteil AI gibt unabhängig vom Modulationsverfahren 144 Tupel von Bits aus. Es sind jeweils 7 RAM-Speicher IRAM1 und QRAM2 vorhanden, wobei jeder RAM-Speicher IRAM1 und QRAM2 1200 Zeilen aufweist. Die Anzahl der Spalten der RAM-Speicher IRAM1 und QRAM2 kann z.B. 12 betragen; dieser Wert hängt von der für die Inverse Fouriertransformation benötigten Auflösung der I- und Q-Werte ab.

Es wurde die Vorgehensweise hinsichtlich des ersten Chunks CHUNK 1 beschrieben. Im Anschluss erfolgt die Bearbeitung der Daten des zweiten Chunks. D.h. sobald die Bytes des ersten chunks CHUNK 1 vollständig aus dem Speicher BUF ausgelesen sind, werden die Bits des nächsten Chunks in den Speicher BUF gegeben. Die Bits des zweiten Chunks werden auf die gleiche Weise verarbeitet wie hinsichtlich des ersten Chunks CHUNK erläutert; jedoch kann sich das Modulationsverfahren und dementsprechend die durch den Bestandteil AI gebildete Tupel-Größe unterscheiden. Die Daten des zweiten Chunks werden in den gleichen RAM-Speichern IRAM1 und QRAM2 abgelegt wie diejenigen des ersten Chunks CHUNK 1. Es findet somit eine serielle Datenbearbeitung statt, und zwar solange, bis die Daten aller Chunks in die RAM-Speicher IRAM1 und QRAM2 abgelegt sind. Hierbei steht für diese Bearbeitungsschritte hinsichtlich aller Chunks ein TTI zur Verfügung. Während der Versendung dieser Daten, d.h. innerhalb des nächsten TTI, erfolgt auf die erläuterte Weise die Verarbeitung der Daten für das darauffolgende TTI. Die Daten eines TTI werden somit innerhalb des TTI vor ihrer Versendung auf die erläuterte Weise verarbeitet. Die Rate, mit welcher der Bestandteil CP und die darauffolgenden Bestandteile periodisch operieren, ergibt sich somit aus der Länge eines TTI geteilt durch die Anzahl der chunks. Auch die Tabelle MAP wird vorzugsweise periodisch erstellt, jedoch mit einer größeren Periodenlänge als ein TTI.

Auf eine detaillierte Erläuterung des empfängerseitigen Vorgehens wird verzichtet. Dieses ergibt sich nämlich aus der senderseitigen Datenverarbeitung: nach der empfängerseitigen Fouriertransformation des gesamten Signals, d.h. der auf allen Subbändern empfangenen Informationen, werden die ermittelten Symbole durch einen Demodulator in Bits umgewandelt.

Ein Deinterleaver führt die Umkehrschritte des Bestandteils AI des Senders durch, so dass durch den Deinterleaver die von dem Demodulator ausgegebenen Tupel von Bits in Bytes unter Änderung der Reihenfolge der Bits umgewandelt werden. Hierbei werden analog zur Erläuterung zu Figur 3 acht parallele Schieberegister eingesetzt. Es werden jeweils nacheinander acht von dem Demodulator ausgegebene Tupel in die Schieberegister eingegeben, und die parallele Ausgabe der Schieberegister bildet ein 8er-Tupel von Bits. Bei einer fehlerfreien Funkübertragung sind die empfängerseitig nach dem Deinterleaver vorliegenden 8er-Tupel von Bits identisch mit den 8er-Tupel von Bits am Eingang des senderseitigen Bestandteils AI.

Die Erfindung ist vorteilhaft auf MIMO-OFDM Systeme anwendbar (MIMO: Multiple Input Multiple Output). Hierbei weisen der Sender und der Empfänger jeweils eine Mehrzahl von Antennen auf. In diesem Fall sind die Bestandteile BUF, AI, AM, IRAM1 und QRAM2 jeweils für jede Antenne vorhanden. Abhängig vom verwendeten MIMO-Verfahren ist es möglich, dass von den Bestandteilen BUF, AI, AM, IRAM1 und QRAM2 verschiedener Antennen verschiedene Daten verarbeitet und somit über verschiedene Antennen voneinander unterschiedliche Informationen versendet werden, oder auch, dass die gleichen Informationen über verschiedene Antennen versendet werden.

Die Erfindung eignet sich zwar wie anhand des Ausführungsbeispiels erläutert besonders für die Datenversendung in Abwärtsrichtung; sie kann jedoch auch für Übertragungen in Aufwärtsrichtung eingesetzt werden.

## Patentansprüche

1. Verfahren zur Bearbeitung von per Funk zu versendenden Informationen (DS), bei welchem
erste Bits als erste Anzahl von N-Tupeln vorliegen, und zweite Bits als von der ersten Anzahl unterschiedliche zweite Anzahl von N-Tupeln vorliegen,
die ersten Bits unter Verwendung einer ersten Gruppe von Subbändern eines Frequenzbandes und die zweiten Bits unter Verwendung einer zweiten von der ersten Gruppe unterschiedlichen Gruppe von Subbändern des Frequenzbandes zu versenden sind,
für die ersten Bits ein erstes Modulationsverfahren (MODX, MODY) und für die zweiten Bits ein zweites von dem ersten Modulationsverfahren (MODX, MODY) unterschiedliches Modulationsverfahren (MODX, MODY) eingesetzt wird, die ersten Bits umgeordnet werden, wobei M-Tupel gebildet werden, und gemäß dem ersten Modulationsverfahren (MODX, MODY) aus jeweils einem M-Tupel ein Symbol gebildet wird, die zweiten Bits umgeordnet werden, wobei P-Tupel gebildet werden, und gemäß dem zweiten Modulationsverfahren (MODX, MODY) aus jeweils einem P-Tupel ein Symbol gebildet wird,
wobei *M ≠ P.*

2. Verfahren nach Anspruch 1, bei dem
die Anzahl der M-Tupel gleich der Anzahl der P-Tupel ist.

3. Verfahren nach Anspruch 1 oder 2, bei dem
die Bildung von M-Tupeln erfolgt, indem M N-Tupel der ersten bits in parallele Schiebergister eingegeben werden.

4. Verfahren nach einem der Ansprüche 1 bis 3, bei dem
die Bildung von P-Tupeln erfolgt, indem P N-Tupel der zweiten Bits in parallele Schieberegister eingegeben werden.

5. Verfahren nach Anspruch 3 und 4, bei dem
die gleichen P parallelen Schieberegister zur Bildung der P-Tupel und zur Bildung der M-Tupel verwendet werden.

6. Verfahren nach einem der Ansprüche 1 bis 5, bei dem
ein M-Tupel jeweils Bits von M verschiedenen N-Tupeln der ersten Bits beinhaltet.

7. Verfahren nach, bei dem
ein P-Tupel jeweils Bits von P verschiedenen N-Tupeln der zweiten Bits beinhaltet.

8. Verfahren nach einem der Ansprüche 1 bis 7, bei dem
die Versendung der ersten Bits und der zweiten Bits gleichzeitig erfolgt.

9. Verfahren nach einem der Ansprüche 1 bis 8, bei dem
die Versendung der ersten Bits unter Verwendung einer ersten Funkressourceneinheit und die Versendung der zweiten Bits unter Verwendung einer zweiten Funkressourceneinheit erfolgt,
wobei die Funkressourceneinheiten jeweils ein Rechteck in einer Subband-Zeit-Ebene darstellen,
und die erste und die zweite Funkressourceneinheit gleich groß sind.

10. Verfahren nach Anspruch 9, bei dem
nach der Bildung der Symbole Informationen über die I-Q-Ebene-Positionen der Symbole gespeichert werden,
wobei für jede Zeiteinheit der Rechtecke ein eigener Speicher (IRAM1, QRAM2) verwendet wird.

11. Verfahren nach einem der Ansprüche 1 bis 10, bei dem
die ersten Bits von einer netzseitigen Funkstation (BS) an eine erste Teilnehmerstation (USER1, USER2, USER3, USERN) und die zweiten Bits von der netzseitigen Funkstation (BS) an eine zweite Teilnehmerstation (USER1, USER2, USER3, USERN) versendet werden.

12. Verfahren nach einem der Ansprüche 1 bis 11, bei dem
die Anzahl der ersten Bits und die Anzahl der zweiten Bits ermittelt werden unter Verwendung der Größe der jeweils zur Versendung zu verwendenden Funkressourceneinheit und des jeweils einzusetzenden Modulationsverfahrens (MODX, MODY).

13. Verfahren nach Anspruch 12, bei dem
die ersten Bits nach Ermittlung ihrer Anzahl aus einem ersten einem ersten Empfänger zugeordneten Speicher (FIFO1, FIFON) ausgelesen werden und die zweiten Bits nach Ermittlung ihrer Anzahl aus einem zweiten einem zweiten Empfänger zugeordneten Speicher (FIFO1, FIFON) ausgelesen werden.

14. Verfahren zur Bearbeitung von per Funk empfangenen Informationen, bei welchem
erste unter Verwendung einer ersten Gruppe von Subbändern eines Frequenzbandes empfangene Symbole und zweite unter Verwendung einer zweiten von der ersten Gruppe unterschiedlichen Gruppe von Subbändern des Frequenzbandes empfangene Symbole vorliegen,
für die ersten Symbole ein erstes Demodulationsverfahren und für die zweiten Symbole ein zweites von dem ersten Demodulationsverfahren unterschiedliches Demodulationsverfahren eingesetzt wird,
nach der Demodulation gemäß dem ersten Demodulationsverfahren ausgehend von den ersten Symbolen erste Bits als M-Tupel und gemäß dem zweiten Demodulationsverfahren ausgehend von den zweiten Symbolen zweite Bits als P-Tupel vorliegen, wobei *M ≠ P ,*
die ersten Bits umgeordnet werden, wobei N-Tupel gebildet werden, und die zweiten Bits umgeordnet werden, wobei N-Tupel gebildet werden.

15. Verfahren nach Anspruch 14, bei dem
die Anzahl der M-Tupel gleich der Anzahl der P-Tupel ist.

16. Verfahren nach Anspruch 14 oder 15, bei dem
die Bildung von N-Tupeln der ersten Bits erfolgt, indem N M-Tupel der ersten Bits in parallele Schieberegister eingegeben werden.

17. Verfahren nach einem der Ansprüche 14 bis 16, bei dem
die Bildung von N-Tupeln der zweiten Bits erfolgt, indem N P-Tupel der zweiten Bits in parallele Schieberegister eingegeben werden.

18. Verfahren nach Anspruch 16 und 17, bei dem
die gleichen N parallelen Schieberegister zur Bildung der N-Tupel der ersten Bits und zur Bildung der P-Tupel der zweiten Bits verwendet werden.

19. Verfahren nach einem der Ansprüche 14 bis 18, bei dem
ein N-Tupel der ersten Bits jeweils Bits von N verschiedenen M-Tupeln der ersten Bits beinhaltet.

20. Verfahren nach einem der Ansprüche 14 bis 19, bei dem
ein N-Tupel der zweiten Bits jeweils Bits von N verschiedenen P-Tupeln der zweiten Bits beinhaltet.

21. Verfahren nach einem der Ansprüche 14 bis 20, bei dem
der Empfang der ersten Symbole und der zweiten Symbole gleichzeitig erfolgt.

22. Verfahren nach einem der Ansprüche 14 bis 21, bei dem
der Empfang der ersten Symbole unter Verwendung einer ersten Funkressourceneinheit und der Empfang der zweiten Symbole unter Verwendung einer zweiten Funkressourceneinheit erfolgt,
wobei die Funkressourceneinheiten jeweils ein Rechteck in einer Subband-Zeit-Ebene darstellen,
und die erste und die zweite Funkressourceneinheit gleich groß sind.

23. Verfahren nach Anspruch 22, bei dem
nach dem Empfang der Symbole Informationen über die I-Q-Ebene-Positionen der Symbole gespeichert werden,
wobei für jede Zeiteinheit der Rechtecke ein eigener Speicher verwendet wird.

24. Funkstation (BS) zur Bearbeitung von per Funk zu versendenden Informationen, welcher
erste Bits als erste Anzahl von N-Tupeln vorliegen, und zweite Bits als von der ersten Anzahl unterschiedliche zweite Anzahl von N-Tupeln vorliegen,
mit Mitteln zum Versenden der ersten Bits unter Verwendung einer ersten Gruppe von Subbändern eines Frequenzbandes und der zweiten Bits unter Verwendung einer zweiten von der ersten Gruppe unterschiedlichen Gruppe von Subbändern des Frequenzbandes,
mit Mitteln zum Verwenden für die ersten Bits eines ersten Modulationsverfahrens und für die zweiten Bits eines zweiten von dem ersten Modulationsverfahren unterschiedlichen Modulationsverfahrens,
mit Mitteln zum Umordnen der ersten Bits, wobei M-Tupel gebildet werden, und Mitteln zum Bilden von Symbolen gemäß dem ersten Modulationsverfahren aus jeweils einem M-Tupel,
mit Mitteln zum Umordnen der zweiten Bits, wobei P-Tupel gebildet werden, und Mitteln zum Bilden von Symbolen gemäß dem zweiten Modulationsverfahren aus jeweils einem P-Tupel,
wobei *M≠P.*

25. Funkstation (USER1, USER2, USER3, USERN) zur Bearbeitung von per Funk empfangenen Informationen, welcher
erste unter Verwendung einer ersten Gruppe von Subbändern eines Frequenzbandes empfangene Symbole und zweite unter Verwendung einer zweiten von der ersten Gruppe unterschiedlichen Gruppe von Subbändern des Frequenzbandes empfangene Symbole vorliegen,
mit Mitteln zum Verwenden eines ersten Demodulationsverfahrens für die ersten Symbole und eines zweiten von dem ersten Demodulationsverfahren unterschiedlichen Demodulationsverfahrens für die zweiten Symbole,
wobei nach der Demodulation gemäß dem ersten Demodulationsverfahren ausgehend von den ersten Symbolen erste Bits als M-Tupel und gemäß dem zweiten Demodulationsverfahren ausgehend von den zweiten Symbolen zweite Bits als P-Tupel vorliegen, wobei *M ≠ P,*
mit Mitteln zum Umordnen der ersten Bits, wobei N-Tupel gebildet werden, und zum Umordnen der zweiten Bits, wobei N-Tupel gebildet werden.
